(19) **Europäisches Patentamt**
European Patent Office
Office européen des brevets

(11) **EP 3 924 295 B1**

(12) **EUROPÄISCHE PATENTSCHRIFT**

(45) Veröffentlichungstag und Bekanntmachung des Hinweises auf die Patenterteilung:
**22.05.2024  Patentblatt 2024/21**

(21) Anmeldenummer: **20705167.3**

(22) Anmeldetag: **12.02.2020**

(51) Internationale Patentklassifikation (IPC):
**B81B 3/00** *(2006.01)*

(52) Gemeinsame Patentklassifikation (CPC):
**B81B 3/0051; B81B 3/0062;** B81B 2201/042;
B81B 2203/0163; B81B 2203/0181; B81B 2203/058

(86) Internationale Anmeldenummer:
**PCT/EP2020/053578**

(87) Internationale Veröffentlichungsnummer:
**WO 2020/165239 (20.08.2020 Gazette 2020/34)**

(54) **MEMS UND VERFAHREN ZUM HERSTELLEN DESSELBEN**

MEMS AND METHOD FOR PRODUCING SAME

MEMS ET PROCÉDÉ POUR SA FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.02.2019  DE 102019201889**

(43) Veröffentlichungstag der Anmeldung:
**22.12.2021  Patentblatt 2021/51**

(73) Patentinhaber: **Fraunhofer-Gesellschaft zur Förderung**
**der angewandten Forschung e.V.**
**80686 München (DE)**

(72) Erfinder:
• **GU-STOPPEL, Shanshan**
**25524 Itzehoe (DE)**

• **NIEKIEL, Malte Florian**
**25524 Itzehoe (DE)**
• **LISEC, Thomas**
**25524 Itzehoe (DE)**
• **LOFINK, Fabian**
**25524 Itzehoe (DE)**

(74) Vertreter: **König, Andreas Rudolf et al**
**Schoppe, Zimmermann, Stöckeler**
**Zinkler, Schenk & Partner mbB**
**Patentanwälte**
**Radlkoferstraße 2**
**81373 München (DE)**

(56) Entgegenhaltungen:
**US-A1- 2003 048 244    US-A1- 2011 187 810**
**US-A1- 2014 376 071    US-B1- 6 220 561**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung bezieht sich auf ein mikroelektromechanisches System (MEMS) und auf ein Verfahren zum Herstellen desselben. Die vorliegende Erfindung bezieht sich auf MEMS mit präzise bewegbaren beweglichen Elementen, was durch Stützen des beweglichen Elements durch zwei Säulenstrukturen an einer Hauptoberfläche ermöglicht wird. Die vorliegende Erfindung bezieht sich ferner auf eine 3D-MEMS-Struktur aus einer Nutzplatte, als hebelwirkende Säulen sowie Biegebalken.

Für ein MEMS-Bauteil ist die Minimierung der Chipabmessung ein essentielles Kriterium. Trotz der kleinen Chipabmessung soll die Nutzfläche aber möglichst groß bleiben. Die Flächeneffizienz eines MEMS-Bauteils wird durch den Füll-Faktor beschrieben. Im Falle eines MEMS-Spiegels wird z. B. der Füll-Faktor durch das Verhältnis der Aperturfläche zur Chipfläche definiert. Zumeist wird bei der Entwicklung eines MEMS-Spiegels neben einem hohen Füll-Faktor auch ein großer Kippwinkel der Spiegelplatte angestrebt. Die erreichbare Auslenkung hängt jedoch wesentlich von der Dimension (Länge) der Aktuatoren ab, was zwangsläufig den Füll-Faktor verringert. Das Problem ist nicht auf MEMS-Spiegel beschränkt. Ein hoher Füll-Faktor und große Auslenkungen sind für alle MEMS-Bauteile von Interesse, die auf einer beweglichen Nutzplatte beruhen.

Es gibt bereits MEMS-Bauteile, wo die Aktuatoren unterhalb der Nutzfläche angebracht wurden, um einen hohen Füll-Faktor zu erhalten und gleichzeitig die Länge der Aktuatoren zu gewährleisten. Ein Beispiel ist in Fig. 9 gezeigt, die aus der US 7,428,353 B1 entnommen ist. Die Aktuatoren sind größtenteils unter der Spiegelplatte platziert, wodurch eine große Länge ermöglicht wird. Dieser Ansatz ist sehr effizient, hat jedoch ein Problem, nämlich dass die Spiegelplatte nicht nur die gewünschte Kippbewegung um die Drehachse, sondern auch eine unerwünschte laterale Verschiebung erfährt.

Die laterale Verschiebung bedeutet einen Lichtverlust im Fall eines MEMS-Spiegels. Sie ist von der Höhe der Säule zwischen den Elementen 300 und 301 abhängig, auf der die Spiegelplatte aufgebaut ist. Bei einer großen Spiegelplatte ist eine hohe Säule notwendig, um die gewünschte Kippbewegung geometrisch zu erlauben. Das heißt am Ende, dass für einen MEMS-Spiegel mit einer großen Spiegelplatte bei diesem Ansatz ein Kompromiss zwischen einem eingeschränkten Scanwinkel und einem großen Lichtverlust gefunden werden muss.

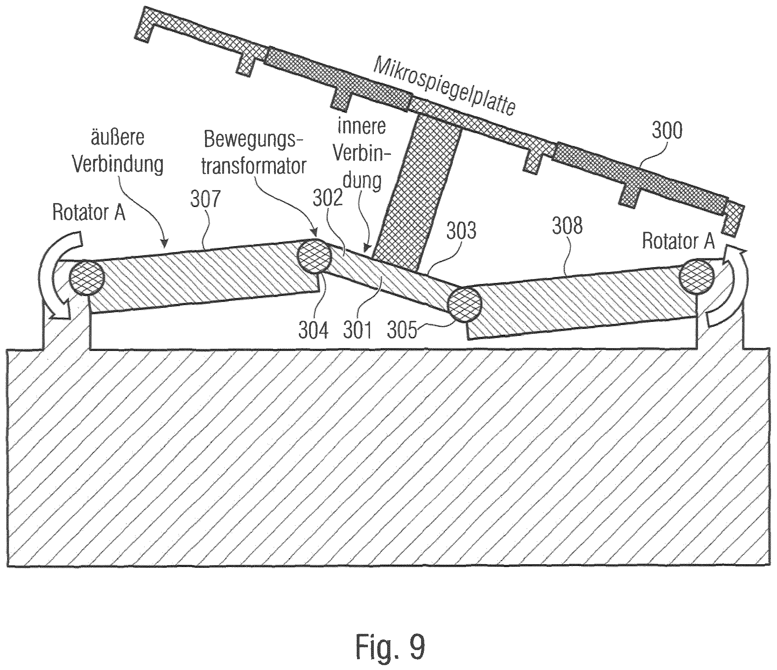

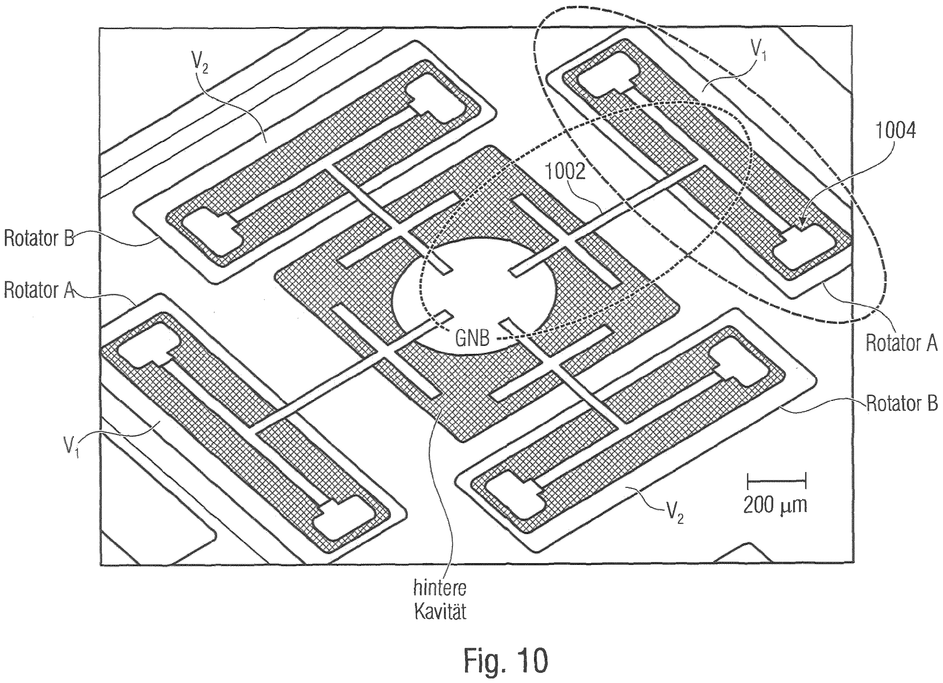

Fig. 10 zeigt eine beispielhafte perspektivische Ansicht eines MEMS-Spiegels, welcher auf dem Ansatz gemäß Fig. 9 basiert. Hier wird eine weitere Einschränkung des Konzepts illustriert. Weil die Gelenke 1002 an den für diesen Ansatz essentiellen Fehlern bzw. Aktuatoren 1004 selbst eine erhebliche Fläche benötigen, kann nur eine eingeschränkte Anzahl von ihnen untergebracht werden. In den meisten Fällen werden die Aktuatoren 1004 orthogonal zueinander entlang der x- und y-Achse angeordnet, um eine zweiachsige Verkippung der Spiegelplatte zu realisieren. Dies hat zur Folge, dass der Spiegel in diagonaler Richtung nur circa 70 % ($\sqrt{2}/2$) des maximalen Kippwinkels in x- oder y-Richtung erzielen kann. Der genaue Wert ist dabei von der individuellen Geometrie eines Bauteils und des verwendeten Aktuations- und Gelenkprinzips abhängig.

Darüber hinaus, Patentschrift US 2014/376071 A1 offenbart eine MEMS Vorrichtung mit drehbarem Element, das mit Säulenstrukturen als Befestigung an Federelementen montiert ist.

Wünschenswert wären MEMS, die eine hohe Flächeneffizienz ermöglichen.

Eine Aufgabe der vorliegenden Erfindung besteht deshalb darin, ein MEMS und ein Verfahren zum Herstellen desselben zu schaffen, das eine hohe Flächeneffizienz ermöglicht.

Diese Aufgabe wird durch den Gegenstand der unabhängigen Patentansprüche gelöst.

Ein Kerngedanke der vorliegenden Erfindung besteht darin, erkannt zu haben, dass durch Aufhängen eines beweglichen Elements über zumindest zwei Säulenstrukturen eine laterale Verschiebung des beweglichen Elements während einer Kippbewegung vermieden werden kann oder zumindest gering sein kann, so dass geringe Zusatzflächen vorgehalten werden müssen und so eine flächeneffiziente Ausgestaltung des MEMS erhalten werden kann. Bei optischen Anwendungen ist ferner ein Lichtverlust gering.

Weitere bevorzugte Ausführungsbeispiele sind der Gegenstand der abhängigen Patentansprüche.

Nachfolgend werden Ausführungsbeispiele unter Bezugnahme auf die beiliegenden Zeichnungen erläutert. Sofern eine bestimmte Ausführungsform erfindungsgemäß ist, wird dies ausdrücklich angegeben.

Es zeigen:

Fig. 1a    eine schematische Seitenschnittansicht eines MEMS gemäß einem Ausführungsbeispiel mit sich nach außen erstreckenden Federelementen;

Fig. 1b    eine schematische Seitenschnittansicht eines MEMS gemäß einem Ausführungsbeispiel mit sich nach innen erstreckenden Federelementen;

Fig. 2    eine schematische Seitenschnittansicht eines MEMS gemäß einem Ausführungsform der Erfindung bei dem die Federelemente Gelenke aufweisen;

Fig. 3a    eine schematische Seitenschnittansicht eines MEMS gemäß einem Ausführungsbeispiel, das eine magnetische Aktuatoreinrichtung umfasst;

Fig. 3b    eine schematische Seitenschnittansicht eines MEMS gemäß einem Ausführungsbeispiel, das die magnetische Aktuatoreinrichtung und sich nach außen erstreckende Federelemente aufweist;

Fig. 4a    eine schematische Seitenschnittansicht eines MEMS gemäß einem Ausführungsbeispiel, mit einer elektrostatischen Aktuatoreinrichtung;

Fig. 4b    eine schematische Seitenschnittansicht eines MEMS gemäß einem Ausführungsbeispiel, das gegenüber dem MEMS aus Fig. 4a einen Federverlauf nach außen aufweist;

Fig. 5    eine schematische Seitenschnittansicht eines MEMS gemäß einem Ausführungsbeispiel, bei dem an oder in den Federelementen ein Elektrodenelement der Aktuatoreinrichtung oder einer Sensoreinrichtung angeordnet ist;

Fig. 6    eine schematische Seitenschnittansicht eines MEMS gemäß einem Ausführungsbeispiel, bei dem die Federelemente ein magnetisches Material oder magnetisierbares Material umfassen;

Fig. 7    eine schematische Ansicht von einer Unterseite eines MEMS gemäß einem Ausführungsbeispiel, das insgesamt zwölf Federelemente aufweist, die rotationssymmetrisch um ein Verkippungszentrum angeordnet sind;

Fig. 8    ein schematisches Flussdiagramm eines Verfahrens gemäß einem Ausführungsbeispiel;

Fig.9    eine Seitenschnittansicht eines bekannten MEMS; und

Fig. 10    eine beispielhafte perspektivische Ansicht eines MEMS-Spiegels, welcher auf dem Ansatz gemäß Fig. 9 basiert.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgende Ausführungsbeispiele beziehen sich auf mikroelektromechanische Systeme (MEMS). Derartige Systeme können in Siliziumtechnologie und/oder komplementärer Metalloxid-Halbleitertechnologie (complementary metal oxide semiconductor, CMOS) hergestellt werden. Strukturen können dabei in der entsprechenden Halbleitertechnologie erzeugt werden, etwa durch Materialabscheidung, können aber auch durch Materialabtrag erhalten werden, etwa durch Verwendung von Ätzprozessen oder Schleifprozessen.

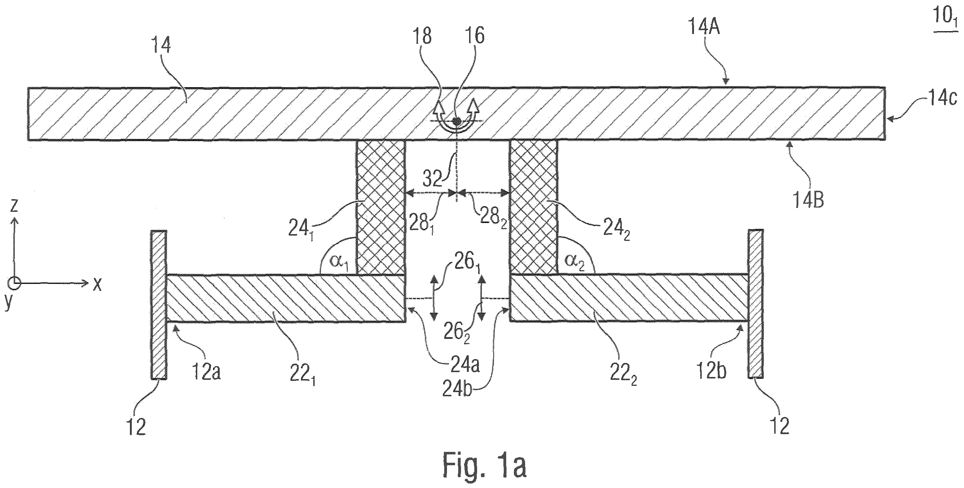

Fig. 1a zeigt eine schematische Seitenschnittansicht eines MEMS $10_1$ gemäß einem Ausführungsbeispiel. Das MEMS $10_1$ umfasst ein Substrat 12, das beispielsweise aus einem Halbleitermaterial, etwa polykristallines oder monokristallines Silizium, Galliumarsenid oder dergleichen umfasst. Im Zusammenhang mit den hierin beschriebenen Ausführungsbeispielen kann das Substrat 12 als unbeweglich betrachtet werden und beispielsweise Teil eines Chips oder dergleichen sein.

Das MEMS $10_1$ umfasst ferner ein bewegliches Element 14, das gegenüber dem Substrat 12 beweglich aufgehängt ist. So kann das bewegliche Element 14 beispielsweise rotatorisch bewegt werden, etwa indem das bewegliche Element 14 um eine Rotationsachse 16 um eine Rotationsachse 16 ausführt. Obwohl die Rotationsachse 16 so dargestellt ist, dass sie ein Volumen des beweglichen Elements 14 in der dargestellten Ruhelage, das bedeutet in Abwesenheit äußerer einwirkender Kräfte, schneidet, kann die Rotationsachse 16 auch außerhalb des Volumens des beweglichen Elements 14 angeordnet sein, etwa benachbart zu einer ersten Hauptoberfläche 14A gegenüberliegend angeordneten zweiten Hauptoberfläche 14B, die dem Substrat zugewandt angeordnet ist. Bevorzugt ist die Rotationsachse 16 möglichst nah an der dargestellten Position innerhalb des Volumens des beweglichen Elements 14 angeordnet.

Die Hauptoberflächen 14A und 14B sind beispielsweise über eine oder mehrere Seitenflächen 14C miteinander verbunden, beispielsweise eine Mantelfläche eines Zylinderkörpers, zu dem die Hauptoberflächen 14A und 14B die Deckelflächen bilden.

Das bewegliche Element kann beispielsweise ein Spiegelelement sein, wobei die Hauptoberfläche 14A spiegelnd gebildet ist. Ausführungsbeispiele sind jedoch nicht hierauf beschränkt. Alternativ oder zusätzlich kann die Hauptoberfläche 14A auch eine andere Funktion, beispielsweise eine elektrisch leitende Funktion aufweisen, so dass das MEMS $10_1$ beispielsweise als elektrischer Schalter verwendbar ist.

Das bewegliche Element 14 kann über Federelemente $22_1$ und $22_2$ an dem Substrat 12 abgestützt oder daran aufgehängt sein. Befestigungsbereiche 12a und 12b, an denen das jeweilige Federelement $22_1$ bzw. $22_2$ mit dem Substrat 12 verbunden ist, können räumlich beabstandet voneinander sein. Die Federelemente $22_1$ und $22_2$ können sich in einem belastungsfreien Zustand des MEMS in einer Ebene parallel zu der Hauptoberfläche 14B erstrecken. Durch Kräfte, die durch Aktuatoren eingebracht werden und/oder äußere Kräfte, darunter Gewichtskräfte, kann eine Auslenkung der Federelemente erfolgen.

Zwischen dem Federelement $22_1$ und der

Hauptseite 14B kann eine Säulenstruktur $24_1$ angeordnet sein, die gegenüber dem Federelement $22_1$ als Starrkörper betrachtet werden kann und im regulären Betrieb des MEMS $10_1$ näherungsweise keine Verformung erfährt oder ausführt.

Die Hauptoberflächen 14A und 14B können sich parallel zu einer x/y-Ebene im Raum angeordnet befinden. Parallel hierzu können die Federelemente $22_1$ und $22_2$ angeordnet sein. Die Federelemente $22_1$ und $22_2$ können so ausgebildet sein, dass sie eine Out-ofplane-Bewegung, das bedeutet eine Bewegung aus der Ebene heraus, bezogen auf Ebenen parallel zu der x/y-Ebene ausführen können, wenn äußere Kräfte auf sie einwirken, etwa unter Verwendung von Aktuatoren. Hierdurch können dem Substrat 12 abgewandte Enden 24a und 24b der Federelemente $22_1$ bzw. $22_2$ entlang der Richtung z senkrecht zu y und x ausgelenkt werden. Das bedeutet, die Enden 24a und 24b können entlang Bewegungsrichtungen $26_1$ bzw. $26_2$ ausgelenkt werden, die zumindest näherungsweise parallel zu der z-Richtung angeordnet ist. Eine gleichphasige Bewegung der Enden 24a und 24b kann eine translatorische Verschiebung des beweglichen Elements 14 entlang positiver z-Richtung oder negativer z-Richtung ermöglichen. Eine gegenphasige Bewegung kann die Rotationsbewegung 18 bereitstellen.

Die Säulenstruktur $24_1$ ist mit einem Winkel $\alpha_1$ gegenüber dem Federelement $22_1$ angeordnet. So kann sich beispielsweise das Federelement $22_1$ in dem dargestellten Ruhezustand im Wesentlichen parallel zu der Hauptoberfläche 14B erstrecken. Die Säulenstruktur $24_1$ kann eine axiale Erstreckung, etwa eine Länge oder Höhe einer Zylinderstruktur, aufweisen, die sich entlang der Bewegungsrichtungen $26_1$ bzw. $26_2$ im Raum erstreckt. Hierdurch kann die Säulenstruktur $24_1$ als Hebel bezüglich der von dem Federelement $22_1$ ausgeführten Bewegung wirken. Entsprechend kann die Säulenstruktur $24_2$ um den Winkel $\alpha_2$ geneigt zu dem Federelement $22_2$ angeordnet sein. Die Säulenstrukturen $24_1$ und $24_2$ können beispielsweise innerhalb fertigungstechnischer Toleranzen senkrecht zu der Hauptoberfläche 14B angeordnet sein, was eine einfache Herstellung ermöglicht. Fertigungstechnische Toleranzen können bspw. durch Ätzprozesse entstehen, die geneigte Seitenwände der Säulenstrukturen 24 hervorrufen können, eine im Wesentlichen senkrechte Ausgestaltung zumindest der zentralen Achse oder neutralen Faser entlang der axialen Erstreckung jedoch unbeeinflusst lassen können.

Die Säulenstrukturen $24_1$ und $24_2$ können ebenfalls Halbleitermaterial umfassen, können jedoch alternativ oder zusätzlich auch andere und insbesondere funktionelle Werkstoffe umfassen, die beispielsweise eine magnetische, piezoelektrische oder elektrisch leitfähige Eigenschaft aufweisen. Eine Geometrie der Säulenstruktur $24_1$ und $24_2$ ist dabei insbesondere im Hinblick auf einen Querschnitt parallel zu einer x/y-Ebene nicht auf runde, ovale oder elliptische Ausführungen beschränkt, sondern kann sich ebenfalls polychron, beispielsweise rechteckig, in dieser Ebene erstrecken.

Bevorzugt sind die Säulenstrukturen $24_1$ und $24_2$ symmetrisch zu der Rotationsachse 16, die auch als Verkippachse bezeichnet werden kann, angeordnet. Hierzu weisen die Säulenstrukturen $24_1$ und $24_2$ bevorzugt gleiche Abstände $28_1$ und $28_2$ zu einer Ebene 32 auf, die sich parallel zur y/z-Ebene im Raum erstreckt und die Rotationsachse 16 schneidet.

Wie es in Fig. 1a dargestellt ist, können sich die Federelemente $22_1$ und $22_2$ ausgehend von den Säulenstrukturen $24_1$ und $24_2$ hin zu dem Substrat 12 nach außen erstrecken, wobei mit "innen" ein Bereich eines Flächenschwerpunkts des beweglichen Elements 14 verstanden werden kann und mit "außen" eine Richtung ausgehend von diesem Punkt hin zu Außenseiten des beweglichen Elements 14.

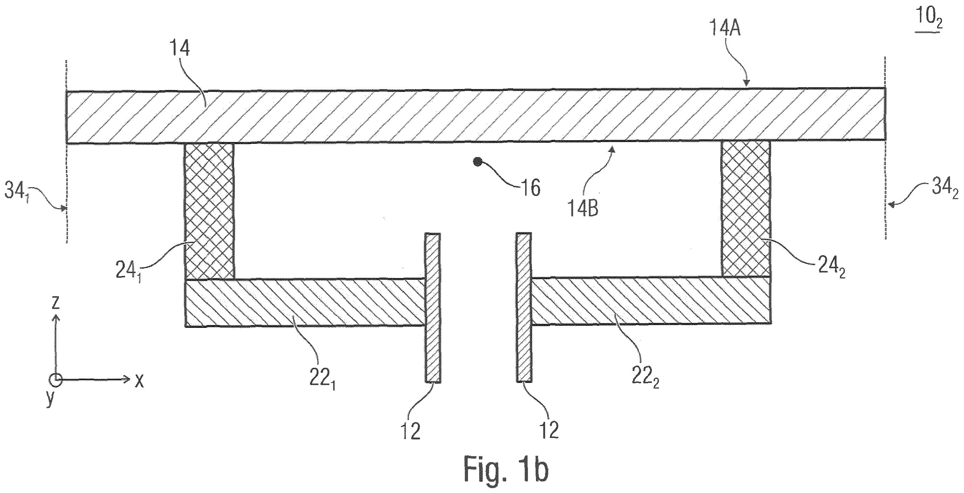

Fig. 1b zeigt eine schematische Seitenschnittansicht eines MEMS $10_2$ gemäß einem Ausführungsbeispiel, das dem MEMS $10_1$ entspricht, bei dem sich jedoch die Federelemente $22_1$ und $22_2$ ausgehend von den Säulenstrukturen $24_1$ und $24_2$ nach innen erstrecken. Hierzu sind die Säulenstrukturen $24_1$ und $24_2$ verglichen mit dem MEMS $10_1$ mit einem größeren Abstand zueinander und zu der Rotationsachse 16 angeordnet. Verglichen mit dem MEMS $10_1$ ermöglicht dies eine präzisere Steuerung des beweglichen Elements 14, gegebenenfalls auf Kosten einer durch die Säulenstrukturen $24_1$ und $24_2$ erhaltenen Hebelwirkung. Diese Hebelwirkung ist von einem Abstand der Säulenstrukturen $24_1$ und $24_2$ zu der Rotationsachse 16 beeinflusst. Diese Einbußen können jedoch durch entsprechende Geometrien der Federelemente $22_1$ und $22_2$, durch Längen der Säulenstrukturen $24_1$ und $24_2$, durch Aktuatorkräfte und weitere Mittel, die hierin beschrieben werden, ausgeglichen werden.

Die Darstellung der Fig. 1b unterscheidet sich ferner von der Fig. 1a dadurch, dass die Rotationsachse 16 benachbart zu der Hauptoberfläche 14B angeordnet ist. Beispielsweise ist sie außerhalb eines Volumens des beweglichen Elements 14 angeordnet. Die exakte Position der Rotationsachse 16 kann durch die Geometrie der Federelemente $22_1$ und $22_2$ sowie der Säulenstrukturen $24_1$ und $24_2$ beeinflusst sein.

Ähnlich wie es für das MEMS $10_1$ dargestellt ist, ist auch das MEMS $10_2$ so ausgeführt, dass die Säulenstrukturen $24_1$ und $24_2$, die Federelemente $22_1$ und $22_2$ optional das Substrat 12 sowie eine möglicherweise angeordnete Aktuatorik von der Hauptseite 14B verdeckt ist, vereinfacht ausgedrückt sind diese Elemente unterhalb des und/oder hinter dem beweglichen Elements 14 angeordnet. Dies kann auch so verstanden werden, dass die genannten Elemente über Seiten $34_1$ und $34_2$, die durch eine Projektion des beweglichen Elements 14 in eine x/y-Ebene entlang der z-Richtung definiert werden, nicht überragt. Ausführungsbeispiele sind jedoch nicht hierauf beschränkt. Gemäß weiteren Ausführungsbeispielen ragen das Federelement $22_1$ und $22_2$ in einem Umfang von höchstens 50 %, bevorzugt höchstens 30 % und noch bevorzugter höchstens 10 % über die Nutzfläche der Hauptoberfläche 14A hinaus, d. h., überragen die Seiten $34_1$ und $34_2$.

In anderen Worten zeigen Fig. 1a und 1b Ausführungsbeispiele eines MEMS-Bauteils mit einer beweglichen Nutzfläche, zwei Stützelementen, zwei flexiblen Federn und zwei Fixierungen, d. h., dem Substrat 12.

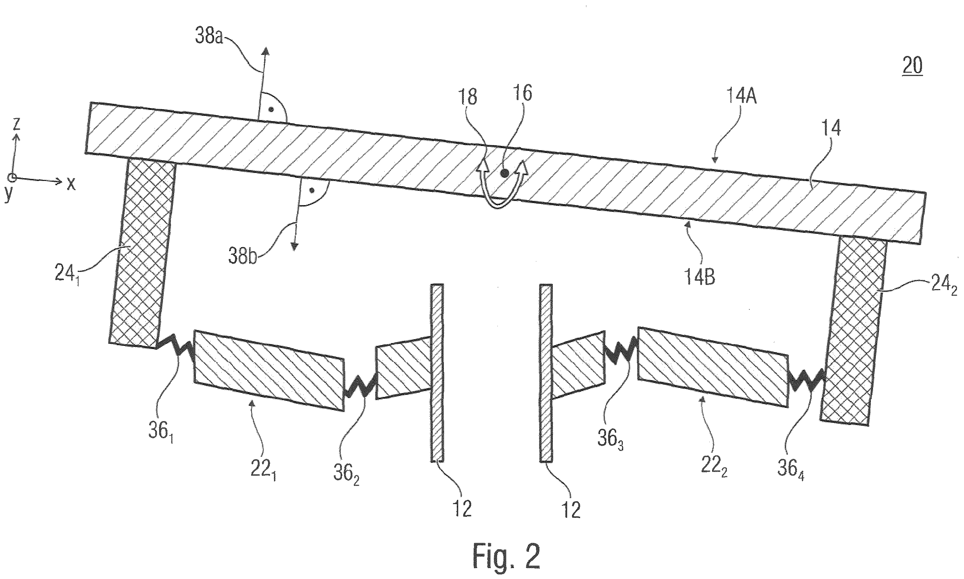

Fig. 2 zeigt eine schematische Seitenschnittansicht eines MEMS 20 gemäß einer Ausführungsform der Erfindung, dessen Struktur auf der Struktur des MEMS $10_2$ basiert, wobei die Erläuterungen ebenso für eine Struktur gemäß dem MEMS $10_1$ gültig sind. Die Federelemente $22_1$ und $22_2$ können ein oder mehrere Gelenke 36 aufweisen. Gelenke können Abschnitte der Federelemente $22_1$ und/oder $22_2$ und/oder eigens hierfür eingebrachte oder vorgesehene Elemente sein, die dafür vorgesehen sind, sich gegenüber anderen Bereichen der Federelemente $22_1$ und/oder $22_2$ besonders stark zu verformen, so dass hier die Verformung konzentriert werden kann und die anderen Bereiche vergleichsweise starr sein können. Im Bereich der Gelenke kann bspw. eine zumindest 1,5-fache, 2-fache, 3-fache oder stärkere Verformung erfolgen als in den übrigen Bereichen.

Ausführungsbeispiele sehen vor, dass die Federelemente $22_1$ und $22_2$ beide mit Gelenken 36 versehen sind, was eine symmetrische Federkraft für die Rotationsbewegung 18 in beide Richtungen ermöglicht. Andere Ausführungsbeispiele sehen dahingegen vor, dass lediglich eines der Federelemente $22_1$ oder $22_2$ mit einem Gelenk 36 versehen ist, dass eine unterschiedliche Anzahl von Gelenken 36 vorgesehen ist und/oder dass eine Steifigkeitsreduzierung, die durch die in den Federelementen $22_1$ bzw. $22_2$ vorgesehenen Gelenke insgesamt oder zumindest örtlich bezogen unterschiedlich ist. Hierdurch lässt sich eine Einstellung der Bewegungsamplitude der Rotationsbewegung 18 einstellen, so dass beispielsweise durch gleich ausgebildete Aktuatoren oder gleiche Aktuatorkräfte unterschiedliche Bewegungsamplituden in unterschiedliche Richtungen erhalten werden kann, was eine einfache Ansteuerung ermöglicht.

Eines oder mehrere der Gelenke $36_1$ bis $36_4$ kann durch eine lokale Veränderung eines Federmaterials und/oder durch eine lokale Veränderung einer Federstruktur der Federelemente $22_1$ bzw. $22_2$ zumindest teilweise implementiert sein, wobei auch Kombinationen möglich sind. So kann eine lokale Veränderung der Federstruktur beispielsweise eine Ausdünnung des Federelements umfassen. Die Gelenke $36_1$, $36_2$, $36_3$ und/oder $36_4$ können alternativ oder zusätzlich auch durch ein von Materialien des Federelements $22_1$ und/oder $22_2$ verschiedenen Materialien implementiert sein, wobei sich hierfür insbesondere funktionelle Materialien, etwa elektrisch leitfähige, magnetisch oder mikromagnetische und/oder piezoelektrische Materialien, anbieten können, die eine Übertragung oder Erzeugung von Kräften ermöglichen.

In anderen Worten können die Gelenke $36_1$, $36_2$, $36_3$ und/oder $36_4$ bei erfindungsgemäßen MEMS-Vorrichtungen oder MEMS-Aktuatoren als eine lokale, weichere Struktur, etwa umfassend gefaltete Federn, des Biegebalkens realisiert werden, wenn die Kraft über die Biegebalkenstruktur, etwa Federn oder piezoelektrische und/oder thermische Aktuatoren, fortschreitend, auf einer ableitbaren Weise, d. h. kontinuierlich, weitergeleitet wird. Alternativ hierzu kann zumindest eines der Gelenke $36_1$ bis $36_4$ auch als ein Wendepunkt der Federn sein bzw. an einem Ort angeordnet sein, an dem eine Biegelinie der Federelemente $22_1$ bzw. $22_2$ einen Wendepunkt einer Ableitungsfunktion definiert, da dort Kraft lokal und konzentrierend auf diesen Punkt einwirkt, etwa durch kapazitive oder magnetische Kräfte.

Durch Anordnung von Gelenken $36_1$ bis $36_4$ können Hebelwirkungen vergrößert oder Verringerungen derselben kompensiert werden. So kann nicht nur das MEMS $10_2$ mit einem oder mehreren Gelenken in einem oder mehreren Federelementen erweitert werden, es besteht auch die Möglichkeit, das MEMS $10_1$ durch entsprechende Federelemente zu erweitern. Unter erneuter Bezugnahme auf die Fig. 1a und 1b lösen beide Vorrichtungen das Problem der lateralen Verschiebung der beweglichen Nutzfläche des beweglichen Elements 14, innerhalb eines MEMS-Bauteils, wenn diese verkippt wird und ermöglicht den gleichen hohen Kippwinkel unabhängig von der Kipprichtung. Die Nutzfläche kann die Apertur-Platte eines MEMS-Spiegels sein, die Erfindung ist jedoch nicht auf MEMS-Spiegel beschränkt. Ein erstes wesentliches Merkmal der Erfindung besteht darin, dass die bewegliche Nutzfläche von Stützelementen, den Säulenstrukturen 24, getragen wird, die wiederum an flexiblen Federn, den Federelementen 22, aufgehängt sind. Fig. 1a und Fig. 1b zeigen mögliche Ausführungsbeispiele unter Verwendung zweier säulenförmiger Stützelemente. Wichtig ist hierbei, dass sich die Verbindungspunkte der Stützelemente mit den flexiblen Federn abseits des Rotationszentrums 16 sowie der Ebene 32 befinden. Aus dieser Sicht können die Stützelemente, die vor allem als Hebel dienen, beliebige Formen annehmen und auch ineinander übergehen, auch wenn die hierin beschriebenen Ausführungsbeispiele getrennt angeordnete, säulenförmige Stützelemente beschreiben. Je größer der Abstand zwischen den Stützelementen ist, etwa durch Vergrößerung des Abstands beim MEMS $10_2$ verglichen mit dem MEMS $10_1$, desto geringer kann die durch die Verkippung ausgelöste laterale Verschiebung des beweglichen Elements 14 ausfallen. Bei gleichen geometrischen Abmessungen der Säulenstrukturen, der Federelemente und des beweglichen Elements kann es deshalb auftreten, dass die laterale Verschiebung des MEMS $10_2$ geringer ist als die laterale Verschiebung des MEMS $10_1$. Dahingegen weist jedoch das MEMS $10_1$ den Vorteil einer stärkeren erzielten Hebelwirkung auf, da der Wirkungspunkt an den freien Enden der flexiblen Federn, also der Übergang zu den Säulenstrukturen 24, näher am Rotationszentrum der Nutzfläche liegt.

Die Gelenke $36_1$ bis $36_4$ können nun unter anderem dafür genutzt werden, die gegenüber dem MEMS $10_1$ verringerte Hebelwirkung des MEMS $10_2$ zumindest

teilweise zu kompensieren, indem der Hebel durch die Gelenke $36_1$ bis $36_4$ innerhalb der flexiblen Federn $22_1$ und $22_2$ verstärkt wird. Obwohl zwei Federelemente $36_1$ und $36_2$ bzw. $36_3$ und $36_4$ dargestellt sind, kann eine andere Anzahl von Gelenken $\geq 0$ implementiert sein, beispielsweise zumindest 1, zumindest 2, zumindest 3 oder zumindest 4. Die Gelenke 36 können beispielsweise durch Faltung der Feder realisiert werden.

Orte der Anordnung von Gelenken 36 in dem Federelement können dabei abhängig von den Bedarfen des MEMS gewählt werden. Je geringer ein Abstand des Gelenks bezüglich des Substrats 12, desto effektiver ist das Gelenk im Hinblick auf die Verstärkung der Hebelwirkung. Gleichzeitig liefert das Gelenk dort aber einen höheren Widerstand. Andersherum führt eine weiche Stelle durch ein Gelenk zu einer großen Auslenkung, gleichzeitig verbraucht eine Eigendeformation aber in die Federelemente 22 eingebrachte Kräfte und kann deshalb zu einer geringeren Aktuatorwirkung führen. Die Gelenke 36 können darüber hinaus dafür genutzt werden, eine Verschiebung des beweglichen Elements 14 entlang der z-Richtung zu korrigieren. Hierfür sehen Ausführungsbeispiele eine Anordnung der Gelenke $36_1$ oder $36_4$ in einem Übergangsbereich zwischen dem Federelementen $22_1$ bzw. $22_2$ und der zugeordneten Säulenstruktur $24_1$ bzw. $24_2$ vor, um eine Korrektur oder Kompensation einer Verschiebung des beweglichen Elements 14 entlang der z-Richtung zu ermöglichen.

Unterschiedliche Implementierungen der Gelenke 36 können darin übereinstimmen, dass entlang einer Richtung parallel zu einer Oberflächennormalen 38b der Hauptoberfläche 14B eine Steifigkeitsreduzierung erhalten wird. Bei einer planparallelen Ausgestaltung kann dies auch eine Steifigkeitsreduzierung parallel zu einer Oberflächennormalen 38a der Hauptoberfläche 14A bedeuten. Hierfür kann jeweils der möglicherweise fiktive Zustand eines unbeeinflussten bzw. kraftlosen MEMS herangezogen werden.

Ausführungsbeispiele sehen vor, dass ein Federelement ein Gelenk benachbart zu der Säulenstruktur aufweist, etwa die Gelenke $36_1$ und $36_4$. Darüber hinaus können die Federelemente ein weiteres Gelenk aufweisen, das benachbart zum Substrat angeordnet ist, beispielsweise die Gelenke $36_2$ und $36_3$. Die Gelenke $36_2$ und $36_3$ können auch direkt am Substrat 12 angeordnet sein, alternativ oder zusätzlich ist es möglich, dass die Gelenke $36_1$ und/oder $36_4$ durch einen regulären oder anderen Abschnitt des Federelements von der Säulenstruktur 24 beabstandet sind, analog zu der Beabstandung vom Substrat 12.

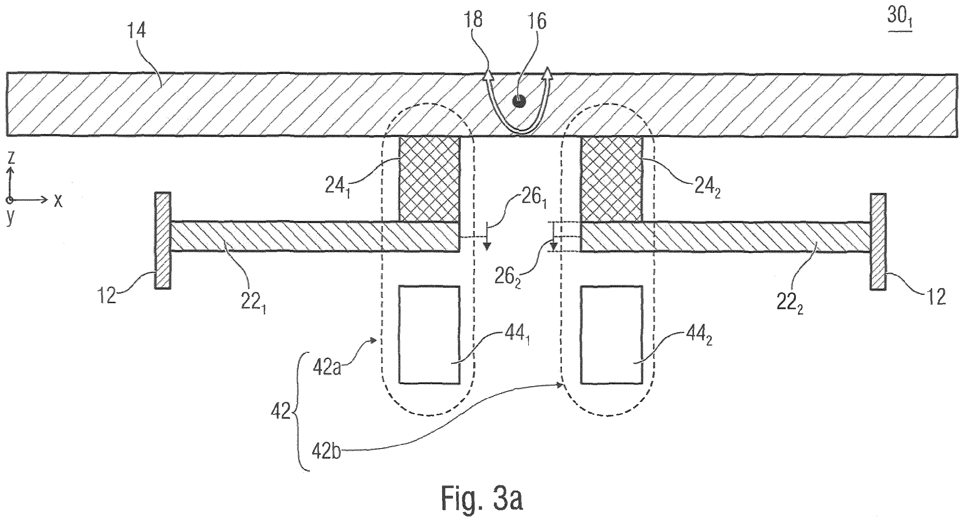

Fig. 3a zeigt eine schematische Seitenschnittansicht eines MEMS $30_1$ gemäß einem Ausführungsbeispiel, dessen Struktur auf der Struktur des MEMS $10_1$ basiert, wobei die Erläuterungen ebenso für eine Struktur gemäß dem MEMS $10_2$ gültig sind. Das MEMS $30_1$ umfasst eine Aktuatoreinrichtung 42, die zumindest einen Teil 42a und/oder 42b umfasst, wobei jeder Teil 42a und 42b ausgebildet ist, um eine Kraft in zumindest einem

Federelement $22_1$ und/oder $22_2$ zu erzeugen, um eine Auslenkung des beweglichen Federelements 14 zu bewirken. Der Aktuatorteil 42a kann ausgebildet sein, um eine Aktuatorkraft in einem Bereich der Säulenstruktur $24_1$ zu erzeugen. Der Teil 42b kann ausgebildet sein, um eine Kraft im Bereich der Säulenstruktur $24_2$ zu erzeugen, so dass basierend auf der erzeugten Kraft eine Auslenkung der Säulenstruktur $24_1$ und/oder $24_2$ erhalten werden kann, was über die Abstützung derselben an dem Substrat 12 mittels der Federelemente $22_1$ und $22_2$ in eine translatorische und/oder rotatorische Bewegung des beweglichen Federelements 14 überführt werden kann.

Beispielsweise kann der Aktuator 42 zumindest eines aus einer thermisch induzierten Aktuatorkraft, einer piezoelektrisch induzierten Aktuatorkraft, einer elektrostatisch induzierten Aktuatorkraft und einer magnetisch induzierten Aktuatorkraft bereitstellen. Alternativ oder zusätzlich zu einer Erzeugung einer Kraft, die an den Säulenstrukturen $24_1$ und/oder $24_2$ wirkt, kann auch eine Kraft an oder in den Federelementen $22_1$ und/oder $22_2$ erzeugt werden, so dass die Aktuatorkraft in einem Bereich des jeweiligen Federelements $22_1$ und/oder $22_2$ erzeugt wird.

So kann die Säulenstruktur $24_1$ und/oder die Säulenstruktur $24_2$ ein magnetisches Material oder alternativ ein magnetisierbares Material aufweisen. Die Aktuatoreinrichtung 42 kann ausgebildet sein, um benachbart zu dem magnetischen Material ein magnetisches Feld zu erzeugen, um eine Bewegung des beweglichen Elements 14 zu bewirken. So können beispielsweise steuerbare Magnete $44_1$ und $44_2$ in räumlicher Nachbarschaft zu den Säulenstrukturen $24_1$ bzw. $24_2$ angeordnet sein, so dass durch Aktivierung des Magnets $44_1$ eine magnetische Kraft zwischen dem Magnet $44_1$ und der Säulenstruktur $24_1$ zum Bewirken der Bewegung des beweglichen Elements 14 an diesem Ort entlang der Bewegungsrichtung $26_1$ erfolgt. Durch Aktivieren des Magnets $44_2$ kann eine Kraft zwischen dem Magnet $44_2$ und der Säulenstruktur $24_2$ erhalten werden, was zu einer Auslenkung der Säulenstruktur $24_2$ und mithin des beweglichen Elements 14 entlang der Bewegungsrichtung $26_2$ führen kann. Eine phasengleiche Aktivierung der Magnete $44_1$ und $44_2$ kann somit eine translatorische Bewegung des beweglichen Elements 14 entlang positiver oder negativer Bewegungsrichtung 26 bewirken, während eine gegenphasige Ansteuerung zu der Rotationsbewegung 18 führen kann.

In anderen Worten können die Stützelemente bzw. Säulen ein hartmagnetisches Material umfassen, so dass sie mittels magnetischer Felder, z. B. erzeugt durch Spulen, aktiv bidirektional bewegt werden können.

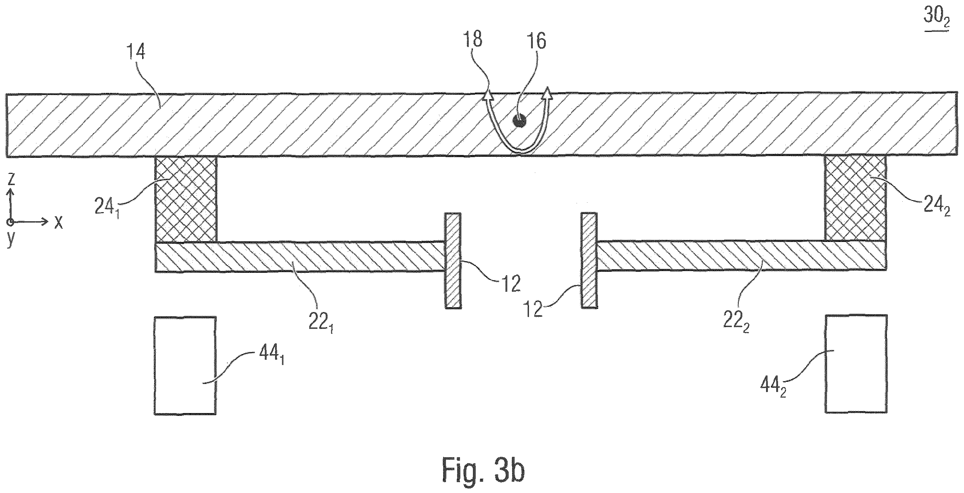

Fig. 3b zeigt eine schematische Seitenschnittansicht eines MEMS $30_2$, dessen Struktur auf der Struktur des MEMS $10_2$ basiert, wobei die Erläuterungen ebenso für eine Struktur gemäß dem MEMS $10_1$ gültig sind. Ähnlich zur Struktur des MEMS $10_2$ sind die Federelemente $22_1$ und $22_2$ ausgehend von dem Substrat 12 nach außen gerichtet sind. Die Säulenstrukturen $24_1$ und $24_2$ können magnetisierbares oder magnetisches Material umfassen, wie es im Zusammenhang mit dem MEMS $30_1$ beschrieben ist. Die Säulenstrukturen $24_1$ und $24_2$ können so gebildet sein, dass sie als Magnete gebildet sind oder Magnete umfassen. So können beispielsweise leistungsfähige NdFeB-Mikromagnete (Neodym-Eisen-Bor) angeordnet werden. Dies kann beispielsweise mittels Agglomeration von mikrometergroßem Pulver mittels ALD (atomic layer deposition, Atomlagenabscheidung) hergestellt und auf Substratebene in MEMS-Bauteile integriert werden. Ein derartiges Verfahren ist beispielsweise in [1] oder [2] beschrieben. Signifikate Kräfte können bereits mit Mikromagneten mit Durchmessern zwischen 50 $\mu$m und 500 $\mu$m erzeugt werden, wobei anwendungsspezifisch beliebige Größen und/oder Kräfte verwendet werden können. Die erzeugten Kräfte können über Abstände im Millimeterbereich übertragen werden, was für MEMS-Anwendungen ausreichend ist.

In anderen Worten zeigen die Fig. 3a und 3b Ausführungsbeispiele eines MEMS-Bauteils mit einer beweglichen Nutzfläche, zwei Stützelementen mit darin befindlichen Säulen aus einem hartmagnetischen Material, zwei flexiblen Federn und zwei Fixierungen.

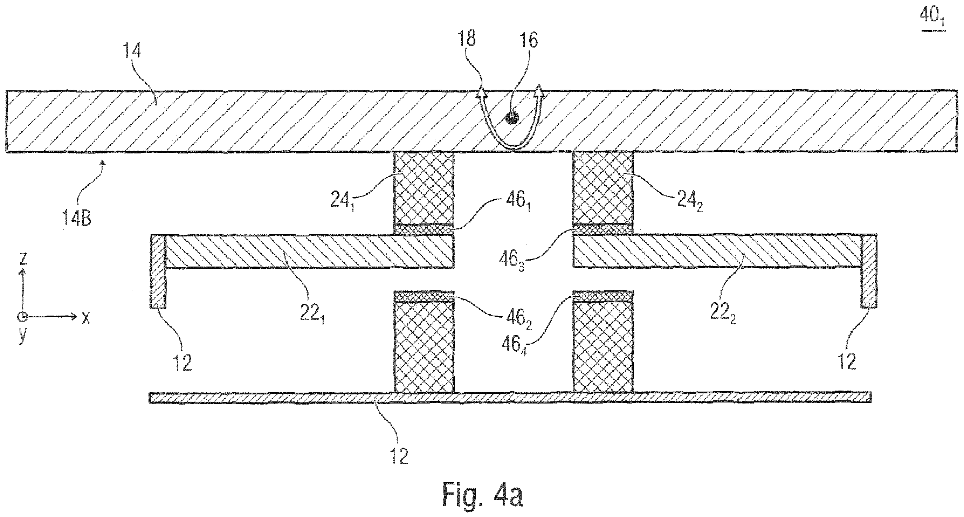

Fig. 4a zeigt eine schematische Seitenschnittansicht eines MEMS $40_1$ gemäß einem Ausführungsbeispiel, dessen Struktur auf der Struktur des MEMS $10_1$ basiert, wobei die Erläuterungen ebenso für eine Struktur gemäß dem MEMS $10_2$ gültig sind. Die Aktuatoreinrichtung weist eine Elektrodenstruktur umfassend Elektroden $46_1$ bis $46_4$ auf, wobei die Elektrodenstruktur jeweils Paare von Elektroden $46_1$ und $46_2$ umfassen kann. Die Elektrodenpaare können jeweils Elektroden $46_1$ und $46_3$ umfassen, die beweglich gegenüber an dem Substrat 12 angeordneten Elektroden $46_2$ bzw. $46_4$ sind, so dass durch die Elektrodenpaare elektrostatische Aktuatoren implementiert werden. Die Elektroden $46_1$ und $46_3$ können beispielsweise an den Säulenstrukturen $24_1$ und $24_2$ angeordnet sein, bevorzugt an der Hauptoberfläche 14B abgewandten Enden derselben, um einen möglichst geringen Abstand zu den jeweils anderen Elektroden $46_2$ und $46_4$ zu erhalten.

Die an dem Substrat 12 angeordneten oder abgestützen Elektroden $46_2$ und $46_4$ können insbesondere im lastfreien Ruhezustand berührungsfrei zu der gegenüberliegenden Säulenstruktur $24_1$ bzw. $24_2$ und dem Federelement $22_1$ bzw. $22_2$ sein.

Unabhängig von der Implementierung des Aktuators können die hierin beschriebenen MEMS so ausgeführt sein, dass das Substrat 12, an dem die Federelemente $22_1$ und $22_2$ angeordnet sind, die Federelemente $22_1$ und $22_2$ entlang positiver z-Richtung, d. h. hin zu der Hauptoberfläche 14B lediglich in einem Umfang von 100 $\mu$m, bevorzugt 50 $\mu$m, noch bevorzugter 10 $\mu$m und insbesondere bevorzugt nicht überragt. Hieraus ergibt sich eine hohe Rotationsamplitude und Bewegungsamplitude des beweglichen Elements 14.

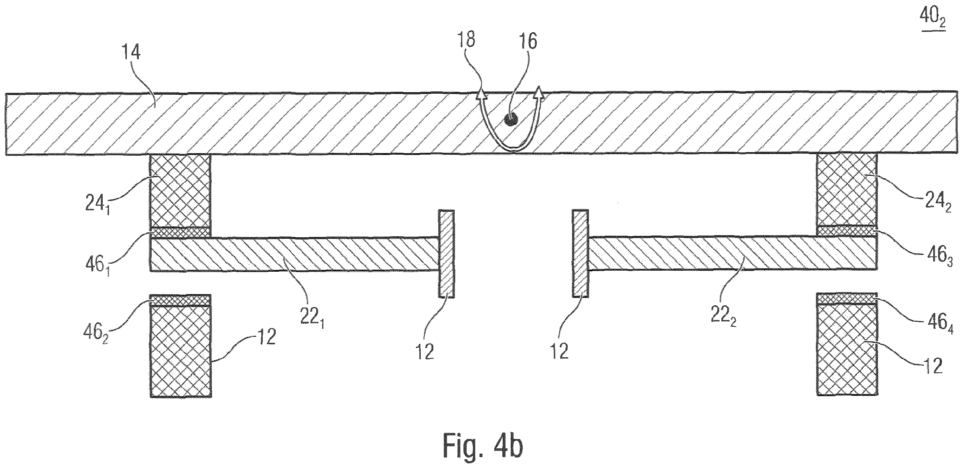

Fig. 4b zeigt eine schematische Seitenschnittansicht eines MEMS $40_2$ gemäß einem Ausführungsbeispiel, das ähnlich aufgebaut ist wie das MEMS $40_1$, jedoch den Federverlauf nach außen implementiert, wie es im Zusammenhang mit dem MEMS $10_2$, 20 und $30_2$ beschrieben ist.

Die Federelemente $22_1$ und $22_2$ der MEMS $40_1$ und $40_2$ können bevorzugt aus einem elektrisch isolierenden Material gebildet sein oder zumindest aus einem Material, das einen Kurzschluss zwischen den Elektroden $46_1$ und $46_2$ bzw. $46_3$ und $46_4$ bei einem mittelbaren Kontakt über die Federelemente $22_1$ bzw. $22_2$ verhindert. Eine ebenso mögliche elektrisch leitfähige Eigenschaft der Federelemente kann dadurch ergänzt werden, dass zwischen dem jeweiligen Federelement $22_1$ bzw. $22_2$ und zumindest einer benachbarten Elektrode $46_1$ und/oder $46_2$ bzw. $46_3$ und/oder $46_4$ eine Isolationsschicht angeordnet wird.

In anderen Worten zeigen die Fig. 4a und 4b Ausführungsbeispiele eines MEMS-Bauteils mit einer beweglichen Nutzfläche, zwei Stützelementen mit kapazitiven Elektroden, zwei flexiblen Federn und zwei Fixierungen. Die Stützelemente, d. h. die Säulenstrukturen, können auch elektrostatisch bewegt werden. Hohe Kräfte können erhalten werden, indem große Elektrodenflächen implementiert werden, beispielsweise durch Stützelemente mit großem Durchmesser oder Elektroden, die die Säulenstrukturen überragen. Alternativ oder zusätzlich können geringe Elektrodenabstände implementiert werden.

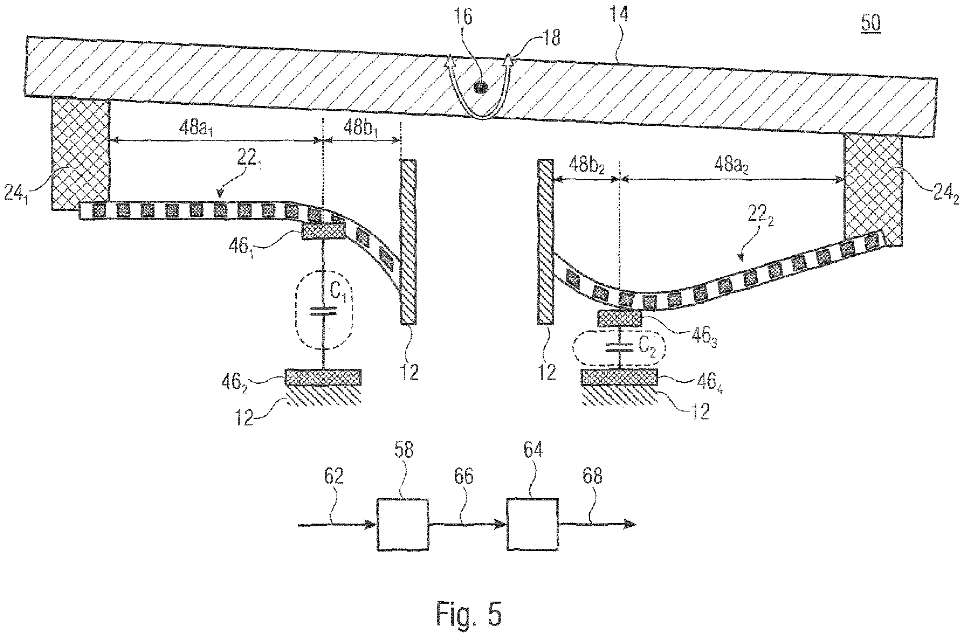

Fig. 5 zeigt eine schematische Seitenschnittansicht eines MEMS 50 gemäß einem Ausführungsbeispiel, bei dem an oder in den Federelementen $22_1$ bzw. $22_2$ ein Elektrodenelement $46_1$ bzw. $46_3$ der Aktuatoreinrichtung angeordnet ist. Beispielhaft erstrecken sich die Federelemente $22_1$ und $22_2$ ausgehend von einer Aufhängung an dem Substrat 12 nach außen, wobei auch eine andere Implementierung, beispielsweise eine nach innen erstreckende, möglich ist.

Anders als es für die MEMS $40_1$ und $40_2$ beschrieben ist, sind die Federelemente $22_1$ und $22_2$ zumindest bereichsweise elektrisch leitfähig gebildet und/oder es ist die Elektrode $46_1$ bzw. $46_3$ daran angeordnet. Es kann vorteilhaft sein, die Aktuatoreinrichtung mit dem Elektrodenpaaren $46_1$ und $46_2$ bzw. $46_3$ und $46_4$ relativ nah, d. h. benachbart zu, dem Substrat 12 anzuordnen, um die hohen Kräfte, die gleichzeitig relativ geringe lokale Stellwege aufweisen, auszunutzen. Im Bedarfsfall können die Elektrodenpaare $46_1$ und $46_2$ bzw. $46_3$ und $46_4$ jedoch auch an einer anderen Stelle angeordnet werden. Die Elektroden $46_1$ und $46_3$ können an oder in einem Material der Federelemente $22_1$ und $22_2$ angeordnet werden. Der in der Fig. 5 dargestellte ausgelenkte Zustand des MEMS 50 kann beispielsweise erhalten werden, wenn lediglich zwischen den Elektroden $46_3$ und $46_4$ eine elektrische Spannung angelegt wird, wodurch eine zwischen den Elektroden $46_3$ und $46_4$ angeordnete elektrische Kapazität $C_2$ beispielsweise eine andere sein kann als zwischen den Elektroden $46_1$ und

$46_2$, wenn zum Erhalten einer gegenläufigen Rotationsbewegung 18 eine elektrische Spannung zwischen diesen Elektroden angelegt wird.

Ein Abstand $48b_1$ zwischen dem Substrat 12 und der Elektrode $46_1$ ins Verhältnis gesetzt mit einem Abstand $48a_1$ zwischen der Elektrode $46_1$ und der Säulenstruktur $24_1$ kann eine erzielbare Hebelwirkung für die Aktuatorauslenkung quantifizieren, ebenso wie ein Verhältnis zwischen den vergleichbaren Abständen $48b_2$ und $48a_2$ zwischen der Elektrode $46_3$ und dem Substrat 12 einerseits und der Säulenstruktur $24_2$ andererseits. Dies kann als Auslegungskriterium für das MEMS 50 genutzt werden. Je größer der Anteil 48a an einer Gesamtlänge des Federelements 22 ist, desto größer kann die erzielbare Hebelwirkung sein.

Das MEMS 50 kann eine Sensoreinrichtung 58 umfassen, die ausgebildet ist, um eine Position und/oder eine Orientierung des beweglichen Elements 14 zu erfassen. Hierfür kann die Sensoreinrichtung 58 ein Eingangssignal 62 von einer hierfür konfigurierten Messeinrichtung erfassen, die die Position und/oder Orientierung des beweglichen Elements 14 elektrisch, optisch, mechanisch und/oder piezoelektrisch erfasst. Gemäß einer Ausführungsform ist die Sensoreinrichtung 58 ausgebildet, um das Eingangssignal 62 von den Elektroden $46_1$ bis $46_4$ zu erhalten, das bedeutet, die Elektroden $46_1$ und $46_4$ können alternativ oder zusätzlich zur Verwendung als Aktuator auch als Sensor genutzt werden.

Eine Steuereinrichtung 64 kann ausgebildet sein, um die Aktuatoreinrichtung zum Auslenken des beweglichen Elements 14 aus seiner Ruhelage basierend auf der erfassten Position und/oder Orientierung des beweglichen Elements 14 zu regeln. Dies ermöglicht es, dass die Steuereinrichtung 64, die zur Steuerung der Aktuatoreinrichtung 42 ausgebildet ist, mit Informationen in Form eines entsprechenden Signals 66 zu versorgen, um ein Ansteuersignal 68 für die Aktuatoreinrichtung 42 so auszugestalten, dass ein geschlossener Regelkreis erhalten wird. Die Verwendung der Elektroden $46_1$ bis $46_4$ im Zusammenhang mit der Sensoreinrichtung 58 kann durch zusätzliche Elemente zur Krafterzeugung kombiniert werden.

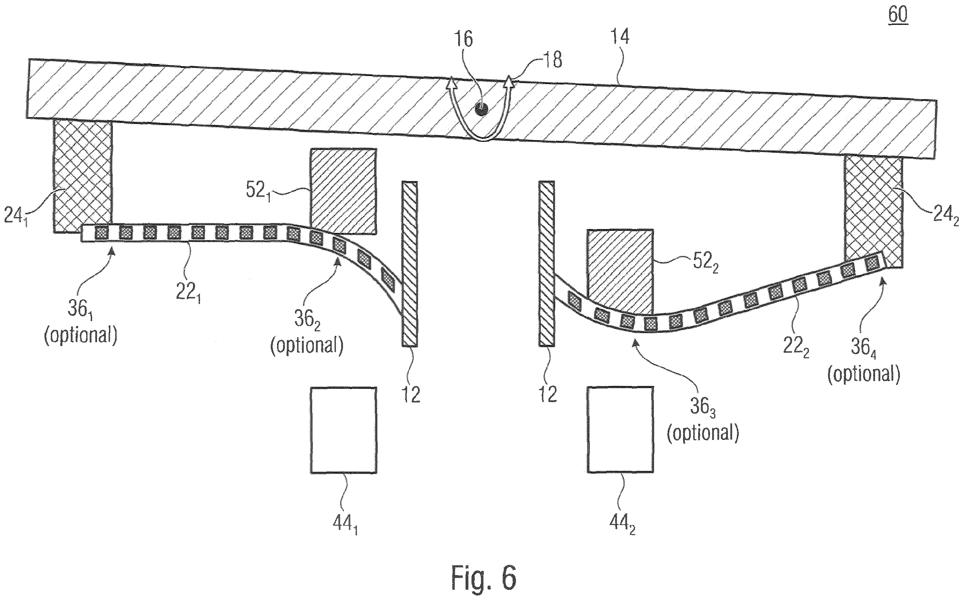

Fig. 6 zeigt eine schematische Seitenschnittansicht eines MEMS 60 gemäß einem Ausführungsbeispiel, bei dem die Federelemente $22_1$ und $22_2$ das im Zusammenhang mit den MEMS $30_1$ und $30_2$ beschriebene magnetische Material oder magnetisierbare Material umfassen. Die Struktur des MEMS 60 kann auf der Struktur des MEMS $10_2$ basieren, wobei die Erläuterungen ebenso für eine Struktur gemäß dem MEMS $10_1$ gültig sind. Das magnetische oder magnetisierbare Material $52_1$ und $52_2$ kann dabei in die Flächenelemente 22 integriert sein, so dass die blockweise Darstellung an den Federelementen $22_1$ und $22_2$ lediglich beispielhaft und schematisch zu verstehen ist. Die Aktuatoreinrichtung kann die Magnete $44_1$ und $44_2$ umfassen, um die zur Auslenkung des beweglichen Elements 14 verwendeten Kräfte zu erzeugen.

Ein Ort der Kraftinduzierung in die Federelemente $22_1$ und/oder $22_2$ kann ebenso wie in Fig. 5 einen Wendepunkt der Biegelinie des Federelements bereitstellen, wobei hier sowohl kontinuierliche als auch diskontinuierliche Änderungen in der Richtung miteingeschlossen sind.

Die Aktuator-Wirkungsweisen der MEMS 50 und 60 können miteinander kombiniert werden. Alternativ oder zusätzlich ist es ebenfalls möglich, thermische und/oder piezoelektrische Aktuatoren einzusetzen, um eine Auslenkung des beweglichen Elements 14 zu erhalten. Die Aktuatoren oder Elemente hiervon können dabei an oder in den Säulenstrukturen $24_1$ und/oder $24_2$, an oder in den Federelementen $22_1$ und/oder $22_2$ und/oder an Übergängen zwischen Federelementen und Säulenstrukturen bzw. Säulenstrukturen und beweglichem Element oder Federelement und Substrat 12 angeordnet sein.

In anderen Worten zeigen die Fig. 5 und 6 Ausführungsbeispiele von MEMS-Bauteilen mit einer beweglichen Nutzfläche, zwei Stützelementen, zwei flexiblen Federn und zwei Fixierungen. Optional können Gelenke $36_1$ bis $36_4$ implementiert werden, wie es im Zusammenhang mit dem MEMS 20 beschrieben ist. Orte der Gelenke 36 können dabei mit Übergängen zwischen den Federelementen 22 und den Säulenstrukturen 24 einerseits und Orten der Krafterzeugung durch die Aktuatoreinrichtung andererseits übereinstimmen, wobei jedes hiervon individuell implementierbar ist. So kann beispielsweise durch Integration des magnetischen Materials 52 in das Federelement 22 ein entsprechendes Gelenk implementiert werden. Das bedeutet, Gelenke können aus kapazitiven Elektroden oder magnetischen Komponenten bestehen oder diese zumindest umfassen.

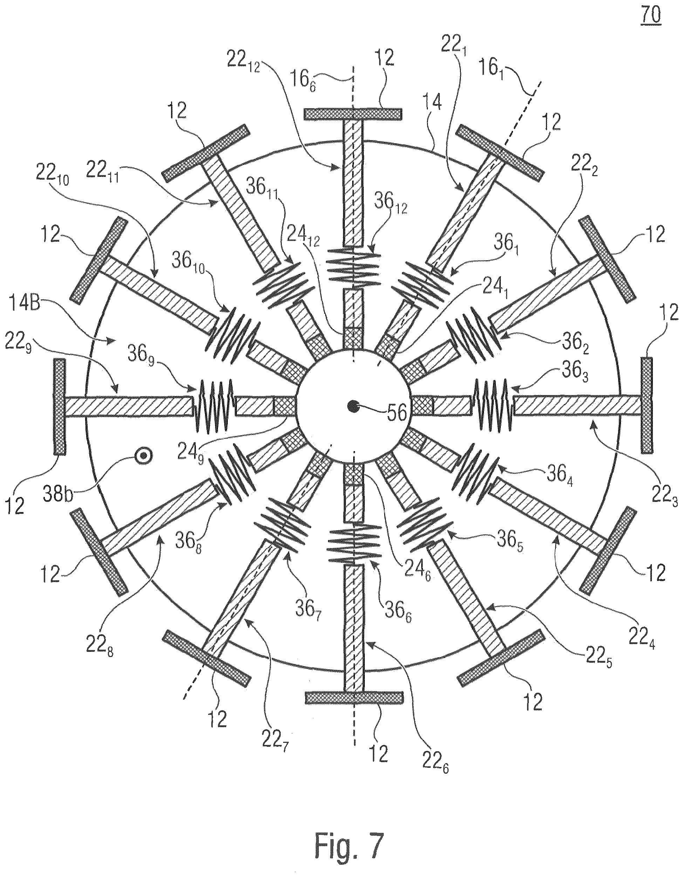

Fig. 7 zeigt eine schematische Ansicht von einer Unterseite eines MEMS 70, das insgesamt eine Anzahl von zwölf Federelementen aufweist, die rotationssymmetrisch um ein Verkippungszentrum 56 angeordnet sind. Obwohl die Federelemente $22_1$ bis $22_{12}$ so dargestellt sind, dass sich ausgehend von den Säulenstrukturen $24_1$ bis $24_{12}$ radial nach außen erstrecken ist auch eine Erstreckung nach innen möglich, wobei auch Mischformen implementiert werden können.

Das Verkippungszentrum 56 kann mit der Rotationsachse 16 zusammenfallen, wobei basierend auf der Anordnung der Federelemente $22_1$ bis $22_{12}$ eine höhere Anzahl von Rotationsachsen erhalten werden kann, beispielsweise sechs. Die Anzahl von zwölf Federelementen $22_1$ bis $22_{12}$, die insgesamt zwölft zugeordnete Säulenstrukturen $24_1$ bis $24_{12}$ mit dem Substrat 12 verbinden, ist lediglich beispielhaft gewählt. Eine mit den MEMS $10_1$, $10_2$, 20, $30_1$, $30_2$, $40_1$, $40_2$, 50 und 60 höhere Anzahl derartiger Elemente umfasst eine beliebige Anzahl $\geq 3$. Das Verkippungszentrum 56 kann bei einer Projektion in die zweite Hauptoberfläche 14B parallel zu der Oberflächennormalen 38b mit einem Flächenschwerpunkt, das bedeutet einem geometrischen Mittelpunkt, der Hauptoberfläche 14B zusammen. Bevorzugt fällt das Verkippungszentrum 56 mit dem Flächenschwerpunkt zumindest innerhalb eines Toleranzbereichs von ± 5 μm, ± 2 μm oder ± 1 μm zusammen. Dies ermöglicht eine hohe Präzision der Auslenkung.

Die zuvor erwähnte gemeinsame Ausführung von Stützelementen wird hier besonders deutlich. So können zumindest einige der Säulenstrukturen $24_1$ bis $24_{12}$ eine gemeinsame Struktur bilden, d. h., mit einander verbunden sein. Beispielsweise kann sich hierdurch eine kreisförmige Struktur, eine ringförmige Struktur oder ein Polygon oder dergleichen ergeben oder auch ein Teil hiervon.

Unterschiedliche Federelemente können dabei entlang unterschiedlicher axialer Erstreckungsrichtungen zwischen der jeweiligen Säulenstruktur und dem Substrat 12 gebildet sein. Während dies beispielsweise für die Federelemente $22_1$ und $22_2$ offensichtlich ist, kann auch eine Anordnung zweier gegenüberliegender Federelemente, etwa $22_1$ und $22_7$ des MEMS 70 oder $22_1$ und $22_2$ der anderen MEMS als gegenläufig verstanden werden und deshalb als verschieden voneinander.

Optional können die Federelemente $22_1$ bis $22_2$ eine auslegungsgemäße Anzahl von Gelenken 36 umfassen, wobei die Anzahl von einem Gelenk lediglich beispielhaft gewählt ist und auch einen anderen Wert aufweisen kann, beispielsweise 0, 2, 3, 4 oder einen höheren Wert.

In anderen Worten zeigt Fig. 7 eine schematische Ansicht eines MEMS-Bauteils mit einer beweglichen Nutzfläche, zwölf Stützelementen, zwölf flexiblen Federn mit Gelenk und zwölf Fixierungen von der Unterseite. Die Konfiguration ermöglicht die platzsparende Integration der Krafterzeugung in die Stützelemente und/oder Federelemente gemäß einem weiteren Merkmal der vorliegenden Erfindung. Im Gegensatz zu bekannten Ansätzen mit vier Aktuatoren, die entlang der x- und y-Achse ausgerichtet sind, können bei diesem Ausführungsbeispiel zwölf Aktuatoren bzw. Stützelemente kreisförmig verteilt sein. Dank dessen kann die Nutzfläche bei gleichbleibend hohem Winkel um eine beliebige Achse gedreht oder verkippt werden. Werden die Stützelemente beispielsweise magnetisch angetrieben, wie es im Zusammenhang mit den Fig. 3a oder 3b beschrieben ist, können Anordnungen gemäß den Fig. 4a und 4b anstelle oder zusätzlich zu der Krafterzeugung auch zur kapazitiven Detektion der Position der Stützelemente genutzt werden, um darauf basierend die Position der Nutzfläche zu bestimmen.

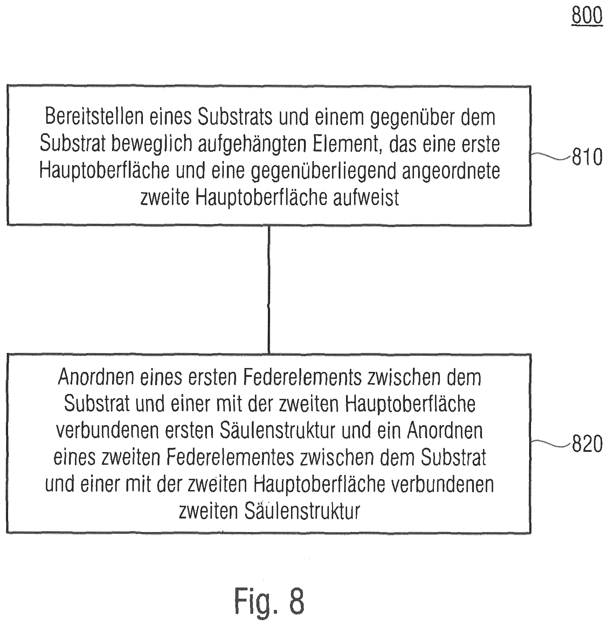

Fig. 8 zeigt ein schematisches Flussdiagramm eines Verfahrens 800 gemäß einem Ausführungsbeispiel, das zum Herstellen eines hierin beschriebenen MEMS verwendet werden kann, beispielsweise dem MEMS $10_1$, $10_2$, 20, $30_1$, $30_2$, $40_1$, $40_2$, 50, 60 und/oder 70. Ein Schritt 810 umfasst ein Bereitstellen eines Substrats und einem gegenüber dem Substrat beweglich aufgehängten Element, das eine erste Hauptoberfläche und eine gegenüberliegend angeordnete zweite Hauptoberfläche aufweist. Ein Schritt 820 umfasst ein Anordnen eines ersten Federelements zwischen dem Substrat und einer mit der zweiten Hauptoberfläche verbundenen ersten Säulenstruktur und ein Anordnen eines zweiten Federelements zwischen dem Substrat und einer mit der zweiten Hauptoberfläche verbundenen zweiten Säulenstruktur, um so das beweglich aufgehängte Element 14 beweglich aufzuhängen.

Gemäß einem Ausführungsbeispiel umfasst das Verfahren 800 einen Schritt des Erzeugens der ersten Säulenstruktur und/oder der zweiten Säulenstruktur durch Abscheiden eines magnetischen Materials, etwa NdFeB, um eine magnetische Säulenstruktur zu erhalten.

Unter erneuter Bezugnahme auf die Fig. 1a kann ein Herstellungsverfahren beispielsweise so ausgeführt werden, dass das Substrat 12 und die Säulenstrukturen 24 und gegebenenfalls auch die Federelemente 22 aus einem gemeinsamen Wafer erhalten werden und beispielsweise durch vorderseitiges Ätzen und/oder rückseitiges Ätzen herausgebildet werden. Das bewegliche Element 14 kann beispielsweise in Form eines weiteren Wafers dann angeordnet werden, beispielsweise mittels Wafer-Bonding.

Ausführungsbeispiele ermöglichen eine Reduzierung der lateralen Verschiebung, beispielsweise entlang der x-Richtung und/oder y-Richtung durch den Aufbau der Nutzfläche auf mehreren Säulen, wodurch auch der Drehpunkt im Raum örtlich stabilisiert wird. Für einen Mikrospiegel kann dies beispielsweise einen geringen Lichtverlust bedeuten, was vorteilhaft ist. Darüber hinaus ermöglichen es Ausführungsbeispiele, die Hebelwirkung, die sich mit steigendem Abstand zwischen den Säulen verringert, durch Gelenke an den Federn wieder zu verstärken. Die Gelenke können weiche Strukturen aufweisen oder bereitstellen oder ein Punkt an den Federn sein, auf den die Antriebskraft konzentriert wird, so dass eine Verformung bereitgestellt wird. Durch die Verwendung der Säulen unterhalb der Nutzfläche zur Krafterzeugung kann der Füll-Faktor des MEMS-Bauteils hoch oder gar sehr hoch sein und gegenüber bekannten Lösungen drastisch erhöht sein. Durch den Einsatz von Magneten oder kapazitiven Elektroden zumindest als Teile der Säulenstrukturen und/oder als Gelenke an den Federelementen kann die Hebelwirkung verstärkt werden und entsprechend große Auslenkungen erhalten werden. Mit den genannten kapazitiven Komponenten ist es möglich, die Position der Nutzfläche zu bestimmen. Durch den Einsatz mehrerer nicht-orthogonaler Aktuatoren/Federn können die Drehachsen flexible definiert werden, so dass z. B. auch um Diagonalen oder Zwischenwinkel ein großer Kippwinkel erzielt werden kann, siehe MEMS 70.

Gemäß einem Ausführungsbeispiel umfasst ein MEMS-Bauteil eine Nutzfläche mit einem oder mehreren Stützelementen und mehreren damit verbundenen, flexiblen Biegebalken, beispielsweise Federn oder Aktuatoren. Die Nutzfläche wird so auf das Stützelement bzw. die Stützelemente aufgebracht, dass sich Stützelemente und Biegebalken unterhalb der Nutzfläche befinden. Die Biegebalken sind an einem Ende mit dem einen oder mehreren Stützelementen und am anderen Ende mit einer Fixierung verbunden. Die Verbindungspunkte der flexiblen Federn mit dem einen oder den mehreren Stützelementen liegt außerhalb der Rotationsachse der Nutzfläche.

Die Stützelemente werden optional als Aktuatoren unter der Nutzfläche für die Krafterzeugung bzw. zur aktiven Positionierung der Nutzfläche genutzt. Alternativ oder zusätzlich werden die Stützstrukturen unter der Nutzfläche derart ausgelegt, so dass die Position des Drehpunktes der Nutzfläche im Raum stabilisiert wird, etwa durch Beabstandung der Anbringungsorte der Federelemente. Alternativ oder zusätzlich können für die Krafterzeugung die Stützelemente Mikromagnete oder Elektrodenflächen umfassen, so dass mittels auf dem Trägerelement fixierten Gegenkomponenten, das bedeutet Ansteuerungsmagnete/Spulen oder Elektroden, eine Wirkkraft auf die Stützelemente ausgeübt und die Nutzfläche aktiv bewegt werden kann. Alternativ oder zusätzlich ist es möglich, die Kombination aus Elektrodenflächen und den entsprechenden Gegenkomponenten zu nutzen, um die Position und/oder Lage der Nutzfläche kapazitiv zu detektieren. Alternativ oder zusätzlich ist es nicht erforderlich, dass Stützelemente und die flexiblen Federn orthogonal angeordnet sind. Insbesondere können sie auch in beliebigem Winkel angeordnet sein, insbesondere unter Verwendung einer Anzahl > 2, um eine flexible Drehachse der darauf angebrachten Nutzplatte zu realisieren. Alternativ oder zusätzlich können die flexiblen Federn Gelenkelemente umfassen. Ein solches Gelenk dient als Knickpunkt des Biegebalkens. Am Knickpunkt wird ein nahezu diskontinuierlicher Verlauf der Biegelinie ermöglicht. Daraus lässt sich eine Hebetwirkung in der Kraftwirkung ausnutzen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Referenzen

[1] Patentschrift EP 2670880 B1, V. Milanovic and K. Castelino, "MEMS device control with filtered voltage signal shaping"
[2] T. Reimer et al., "Temperature-stable NdFeB micromagnets with high-energy density compatible with CMOS back end of line technology", MRS Advances, No. 1, 2016

**Patentansprüche**

1.   MEMS mit:

einem Substrat (12) und einem gegenüber dem Substrat beweglich aufgehängten Element (14), das eine erste Hauptoberfläche (14A) und eine gegenüberliegend angeordnete zweite Hauptoberfläche (14B) aufweist;
einem ersten Federelement ($22_1$), das zwischen dem Substrat (12) und einer mit der zweiten Hauptoberfläche (14B) verbundenen ersten Säulenstruktur ($24_1$) verbunden ist und mit einem zweiten Federelement ($22_2$), das zwischen dem Substrat (12) und
einer mit der zweiten Hauptoberfläche (14B) verbundenen zweiten Säulenstruktur ($24_2$) verbunden ist;
**gekennzeichnet dadurch**
**dass** das erste Federelement ($22_1$) und/oder das zweite Federelement ($22_2$) entlang eines axialen Verlaufs des Federelements ein Gelenk (36) aufweist, das entlang einer Richtung parallel zu einer Oberflächennormalen (38b) der zweiten Hauptoberfläche (14B) eine Steifigkeitsreduzierung des Federelementes ($22_1$, $22_2$) bereitstellt.

2.   MEMS gemäß Anspruch 1, wobei die erste Hauptoberfläche (14A) eine Nutzfläche des MEMS bereitstellt und die Säulenstrukturen ($24_1$, $24_2$) abgewandt von der Nutzfläche angeordnet sind; wobei das erste Federelement ($22_1$) und das zweite Federelement ($22_2$) in einem Umfang von höchstens 50 % über die Nutzfläche herausragen.

3.   MEMS gemäß Ansprüche 1 oder 2, wobei sich das erste Federelement ($22_1$) und das zweite Federelement ($22_2$) ausgehend von der ersten Säulenstruktur ($24_1$) und der zweiten Säulenstruktur ($24_2$) bezogen auf zweite Hauptoberfläche (14B) nach außen erstrecken; oder
wobei sich das erste Federelement ($22_1$) und das

zweite Federelement ($22_2$) sich ausgehend von der ersten Säulenstruktur ($24_1$) und der zweiten Säulenstruktur ($24_2$) bezogen auf zweite Hauptoberfläche (14B) nach innen erstrecken.

4. MEMS gemäß einem der vorangehenden Ansprüche, wobei das Gelenk (36) in einem Übergangsbereich zwischen dem Federelement ($22_1$, $22_2$) und der Säulenstruktur ($24_1$, $24_2$) angeordnet ist.

5. MEMS gemäß einem der vorangehenden Ansprüche, wobei das Gelenk (36) durch eine lokale Veränderung eines Federmaterials und/oder durch eine lokale Veränderung einer Federstruktur zumindest teilweise implementiert ist.

6. MEMS gemäß einem der vorangehenden Ansprüche, wobei das Gelenk (36) durch eine lokale Ausdünnung des Federelementes ($22_1$, $22_2$) zumindest teilweise implementiert ist.

7. MEMS gemäß einem der vorangehenden Ansprüche, wobei das Gelenk (36) eine erstes Gelenk ($36_2$) ist und benachbart zu der Säulenstruktur ($24_1$) angeordnet ist; wobei das Federelement ($22_1$) ein zweites Gelenk ($36_1$) aufweist, die benachbart zum Substrat (12) angeordnet ist.

8. MEMS gemäß einem der vorangehenden Ansprüche, ferner umfassend einen Aktuator (42), der ausgebildet ist, um eine Aktuatorkraft in einem Bereich der ersten Säulenstruktur ($24_1$) und/oder zweiten Säulenstruktur ($24_2$) zu erzeugen, um das bewegliche Element (14) auszulenken; oder umfassend einen Aktuator (42), der ausgebildet ist, um eine Aktuatorkraft in einem Bereich des ersten Federelementes ($22_1$) und/oder zweiten Federelementes ($22_2$) zu erzeugen, um das bewegliche Element (14) auszulenken.

9. MEMS gemäß einem der vorangehenden Ansprüche, wobei an der ersten Säulenstruktur ($24_1$) an einem der zweiten Hauptoberfläche (14B) abgewandten Ende ein erstes Elektrodenelement ($46_1$) einer Aktuatoreinrichtung und an einem der zweiten Hauptoberfläche (14B) abgewandten Ende der zweiten Säulenstruktur ($24_2$) ein zweites Elektrodenelement ($46_3$) der Aktuatoreinrichtung angeordnet ist.

10. MEMS gemäß einem der vorangehenden Ansprüche, wobei die erste Säulenstruktur ($24_1$) und/oder die zweite Säulenstruktur ($24_2$) ein magnetisches Material aufweist und eine Aktuatoreinrichtung (42) des MEMS ausgebildet ist, um benachbart zu dem magnetischen Material ein magnetisches Feld zu erzeugen, um eine Bewegung des beweglichen Elementes (14) zu bewirken; oder

wobei das erste Federelement ($22_1$) und/oder das zweite Federelement ($22_2$) ein magnetisches Material aufweist und eine Aktuatoreinrichtung (42) des MEMS ausgebildet ist, um benachbart zu dem magnetischen Material ein magnetisches Feld zu erzeugen, um eine Bewegung des beweglichen Elementes (14) zu bewirken.

11. MEMS gemäß einem der vorangehenden Ansprüche, wobei an oder in dem ersten Federelement ($22_1$) ein erstes Elektrodenelement ($46_1$) einer Aktuatoreinrichtung (42) und an oder in dem zweiten Federelement ($22_2$) ein zweites Elektrodenelement ($46_3$) der Aktuatoreinrichtung (42) angeordnet ist.

12. MEMS gemäß einem der vorangehenden Ansprüche, ferner umfassend zumindest ein drittes Federelement ($22_3$-$22_{12}$), das zwischen dem Substrat (12) und einer mit der zweiten Hauptoberfläche (14B) verbundenen dritten Säulenstruktur ($24_3$-$24_{12}$) verbunden ist;

wobei die erste Säulenstruktur ($24_1$), die zweite Säulenstruktur ($24_2$) und die dritte Säulenstruktur ($24_3$-$24_{12}$) rotationssymmetrisch um ein Verkippungszentrum (56) des beweglichen Elements (14) angeordnet sind; ferner umfassen eine vierte bis zwölfte Säulenstruktur ($24_1$-$24_{12}$), wobei die erste bis zwölfte Säulenstruktur rotationssymmetrisch um das Verkippungszentrum (56) angeordnet sind und jeweils über ein zugeordnetes Federelement ($22_1$-$22_{12}$) mit dem Substrat (12) verbunden sind.

13. MEMS gemäß einem der vorangehenden Ansprüche, ferner umfassend eine Sensoreinrichtung (58), die ausgebildet ist, um eine Position und/oder Orientierung des beweglichen Elementes (14) zu erfassen.

14. Verfahren (800) zum Herstellen eines MEMS mit folgenden Schritten:

Bereitstellen (810) eines Substrats und einem gegenüber dem Substrat beweglich aufgehängten Element, das eine erste Hauptoberfläche und eine gegenüberliegend angeordnete zweite Hauptoberfläche aufweist;
Anordnen (820) eines ersten Federelementes zwischen dem Substrat und einer mit der zweiten Hauptoberfläche verbundenen ersten Säulenstruktur und Anordnen eines zweiten Federelementes zwischen dem Substrat und einer mit der zweiten Hauptoberfläche verbundenen zweiten Säulenstruktur;
**gekennzeichnet dadurch dass** das erste Federelement ($22_1$) und/oder

das zweite Federelement ($22_2$) entlang eines axialen Verlaufs des Federelements ein Gelenk (36) aufweist, das entlang einer Richtung parallel zu einer Oberflächennormalen (38b) der zweiten Hauptoberfläche (14B) eine Steifigkeitsreduzierung des Federelementes ($22_1$, $22_2$) bereitstellt.

15. Verfahren nach Anspruch 14, umfassend ein Erzeugen der der ersten Säulenstruktur ($24_1$) und/oder der zweiten Säulenstruktur ($24_2$) durch Abscheiden eines magnetischen Materials, um eine magnetische Säulenstruktur zu erhalten.

**Claims**

1. MEMS, comprising:

   a substrate (12) and an element (14) movably suspended relative to the substrate, the element comprising a first main surface (14A) and an opposite second main surface (14B);
   a first spring element ($22_1$) connected between the substrate (12) and a first column structure ($24_1$) connected to the second main surface (14B), and a second spring element ($22_2$) connected between the substrate (12) and a second column structure ($24_2$) connected to the second main surface (14B);
   **characterized in that** the first spring element ($22_1$) and/or the second spring element ($22_2$) comprises, along an axial path of the spring element, a hinge (36) that provides stiffness reduction of the spring element ($22_1$, $22_2$) along a direction parallel to a surface normal (38b) of the second main surface (14B).

2. MEMS according to claim 1, wherein the first main surface (14A) provides a useful area of the MEMS and the column structures ($24_1$, $24_2$) are arranged facing away from the useful area; wherein the first spring element ($22_1$) and the second spring element ($22_2$) protrude beyond the useful area to an extent of at most 50%.

3. MEMS according to claim 1 or 2, wherein the first spring element ($22_1$) and the second spring element ($22_2$) extend outwards from the first column structure ($24_1$) and the second column structure ($24_2$) with respect to the second main surface (14B); or
   wherein the first spring element ($22_1$) and the second spring element ($22_2$) extend inwards from the first column structure ($24_1$) and the second column structure ($24_2$) with respect to the second main surface (14B).

4. MEMS according to one of the preceding claims, wherein the hinge (36) is disposed in a transition area between the spring element ($22_1$, $22_2$) and the column structure ($24_1$, $24_2$).

5. MEMS according to one of the preceding claims, wherein the hinge (36) is at least partially implemented by a local change of a spring material and/or by a local change of a spring structure.

6. MEMS according to one of the preceding claims, wherein the hinge (36) is at least partially implemented by locally thinning the spring element ($22_1$, $22_2$).

7. MEMS according to one of the preceding claims, wherein the hinge (36) is a first hinge ($36_2$) and is disposed adjacent to the column structure ($24_1$); wherein the spring element ($22_1$) comprises a second hinge ($36_1$) disposed adjacent to the substrate (12).

8. MEMS according to one of the preceding claims, further comprising an actuator (42) configured to generate an actuator force in an area of the first column structure ($24_1$) and/or second column structure ($24_2$) to deflect the movable element (14); or
   comprising an actuator (42) configured to generate an actuator force in an area of the first spring element ($22_1$) and/or second spring element ($22_2$) to deflect the movable element (14).

9. MEMS according to one of the preceding claims, wherein a first electrode element ($46_1$) of an actuator is arranged on the first column structure ($24_1$) at an end facing away from the second main surface (14B) and a second electrode element ($46_3$) of the actuator is arranged on an end of the second column structure ($24_2$) facing away from the second main surface (14B).

10. MEMS according to one of the preceding claims, wherein the first column structure ($24_1$) and/or the second column structure ($24_2$) comprises a magnetic material and an actuator (42) of the MEMS is adapted to generate a magnetic field adjacent to the magnetic material to effect movement of the movable element (14); or
    wherein the first spring element ($22_1$) and/or the second spring element ($22_2$) comprises a magnetic material and an actuator (42) of the MEMS is configured to generate a magnetic field adjacent to the magnetic material to effect movement of the movable element (14).

11. MEMS according to one of the preceding claims, wherein a first electrode element ($46_1$) of an actuator (42) is arranged on or in the first spring element ($22_1$) and a second electrode element ($46_3$) of the actuator (42) is arranged on or in the second spring element (22₂).

**12.** MEMS according to one of the preceding claims, further comprising at least a third spring element (22₃-22₁₂) connected between the substrate (12) and a third column structure (24₃-24₁₂) connected to the second main surface (14B);

wherein the first column structure(24₁), the second column structure (24₂), and the third column structure (24₃-24₁₂) are arranged in a rotationally symmetrical manner about a tilting center (56) of the movable element (14); further comprising fourth through twelfth column structures (24₁-24₁₂), wherein the first through twelfth column structures are arranged in a rotationally symmetrical manner about said tilting center (56) and are each connected to the substrate (12) via an associated spring element (22₁-22₁₂),

**13.** MEMS according to one of the preceding claims, further comprising a sensor (58) configured to detect a position and/or orientation of the movable element (14).

**14.** A method (800) of manufacturing an MEMS, comprising:

providing (810) a substrate and an element movably suspended relative to the substrate, the element comprising a first main surface and an opposite second main surface; arranging (820) a first spring element between the substrate and a first column structure connected to the second main surface, and arranging a second spring element between the substrate and a second column structure connected to the second main surface; **characterized in that** the first spring element (22₁) and/or the second spring element (22₂) comprises, along an axial path of the spring element, a hinge (36) that provides stiffness reduction of the spring element (22₁, 22₂) along a direction parallel to a surface normal (38b) of the second main surface (14B).

**15.** The method of claim 14, comprising generating the first column structure (24₁) and/or the second column structure (24₂) by depositing a magnetic material to acquire a magnetic column structure.

**Revendications**

**1.** MEMS avec:

un substrat (12) et un élément (14) suspendu de manière mobile par rapport au substrat qui présente une première surface principale (14A) et une deuxième surface principale disposée de manière opposée (14B); un premier élément de ressort (22₁) qui est connecté entre le substrat (12) et une première structure de colonne (24₁) connectée à la deuxième surface principale (14B) et avec un deuxième élément de ressort (22₂) qui se trouve entre le substrat (12) et une deuxième structure de colonne (24₂) connectée à la deuxième surface principale (14B); **caractérisé par le fait que** le premier élément de ressort (22₁) et/ou le deuxième élément de ressort (22₂) présentent, le long d'un parcours axial de l'élément de ressort, une articulation (36) qui crée, dans une direction parallèle à une normale à la surface (38b) de la deuxième surface principale (14B), une réduction de rigidité de l'élément de ressort (22₁, 22₂).

**2.** MEMS selon la revendication 1, dans lequel la première surface principale (14A) crée une surface utile du MEMS et les structures de colonne (24₁, 24₂) sont disposées éloignées de la surface utile; dans lequel le premier élément de ressort (22₁) et le deuxième élément de ressort (22₂) ressortent de la surface utile selon une étendue de tout au plus 50%.

**3.** MEMS selon les revendications 1 ou 2, dans lequel le premier élément de ressort (22₁) et le deuxième élément de ressort (22₂) s'étendent vers l'extérieur en partant de la première structure de colonne (24₁) et de la deuxième structure de colonne (24₂) par rapport à la deuxième surface principale (14B); ou dans lequel le premier élément de ressort (22₁) et le deuxième élément de ressort (22₂) s'étendant vers l'intérieur en partant de la première structure de colonne (24₁) et de la deuxième structure de colonne (24₂) par rapport à la deuxième surface principale (14B).

**4.** MEMS selon l'une des revendications précédentes, dans lequel l'articulation (36) est disposée dans une zone de transition entre l'élément de ressort (22₁, 22₂) et la structure de colonne (24₁, 24₂).

**5.** MEMS selon l'une des revendications précédentes, dans lequel l'articulation (36) est mise en oeuvre au moins partiellement par une modification locale d'un matériau de ressort et/ou par une modification locale d'une structure de ressort.

**6.** MEMS selon l'une des revendications précédentes, dans lequel l'articulation (36) est mise en oeuvre au moins partiellement par un amincissement local de l'élément de ressort (22₁, 22₂).

**7.** MEMS selon l'une des revendications précédentes, dans lequel l'articulation (36) est une première articulation ($36_2$) et est disposée de manière adjacente à la structure de colonne ($24_1$); dans lequel l'élément de ressort ($22_1$) présente une deuxième articulation ($36_1$) qui est disposée de manière adjacente au substrat (12).

**8.** MEMS selon l'une des revendications précédentes, comportant par ailleurs un actionneur (42) qui est conçu pour générer une force d'actionnement dans une zone de la première structure de colonne ($24_1$) et/ou de la deuxième structure de colonne ($24_2$) pour dévier l'élément mobile (14); ou comportant un actionneur (42) qui est conçu pour générer une force d'actionnement dans une zone du premier élément de ressort ($22_1$) et/ou du deuxième élément de ressort ($22_2$) pour dévier l'élément mobile (14).

**9.** MEMS selon l'une des revendications précédentes, dans lequel est disposé sur la première structure de colonne ($24_1$), à une extrémité éloignée de la deuxième surface principale (14B), un premier élément d'électrode ($46_1$) d'un moyen d'actionnement et, à une extrémité éloignée de la deuxième surface principale (14B) de la deuxième structure de colonne ($24_2$), un deuxième élément d'électrode ($46_3$) du moyen d'actionnement.

**10.** MEMS selon l'une des revendications précédentes, dans lequel la première structure de colonne ($24_1$) et/ou la deuxième structure de colonne ($24_2$) présentent un matériau magnétique et un moyen d'actionnement (42) du MEMS est conçu pour générer un champ magnétique de manière adjacente au matériau magnétique pour provoquer un mouvement de l'élément mobile (14); ou dans lequel le premier élément de ressort ($22_1$) et/ou le deuxième élément de ressort ($22_2$) présentent un matériau magnétique et un moyen d'actionnement (42) du MEMS est conçu pour générer un champ magnétique de manière adjacente au matériau magnétique pour provoquer un mouvement de l'élément mobile (14).

**11.** MEMS selon l'une des revendications précédentes, dans lequel est disposé, sur ou dans le premier élément de ressort ($22_1$), un premier élément d'électrode ($46_1$) d'un moyen d'actionnement (42) et, sur ou dans le deuxième élément de ressort ($22_2$), un deuxième élément d'électrode ($46_3$) du moyen d'actionnement (42).

**12.** MEMS selon l'une des revendications précédentes, comportant par ailleurs au moins un troisième élément de ressort ($22_3$ à $22_{12}$) qui est connecté entre le substrat (12) et une troisième structure de colonne ($24_3$ à $24_{12}$) connectée à la deuxième surface principale (14B);

dans lequel la première structure de colonne ($24_1$), la deuxième structure de colonne ($24_2$) et la troisième structure de colonne ($24_3$ à $24_{12}$) sont disposées de manière symétrique en rotation autour d'un centre d'inclinaison (56) de l'élément mobile (14); comportant par ailleurs une quatrième à douzième structure de colonne ($24_1$ à $24_{12}$), où les première à douzième structures de colonne sont disposées de manière symétrique en rotation autour du centre d'inclinaison (56) et sont connectées, chacune, par l'intermédiaire d'un élément de ressort associé ($22_1$ à $22_{12}$) au substrat (12).

**13.** MEMS selon l'une des revendications précédentes, comportant par ailleurs un moyen capteur (58) qui est conçu pour capter une position et/ou une orientation de l'élément mobile (14).

**14.** Procédé (800) de fabrication d'un MEMS aux étapes suivantes consistant à:

prévoir (810) un substrat et un élément suspendu de manière mobile par rapport au substrat qui présente une première surface principale et une deuxième surface principale opposée; disposer (820) un premier élément de ressort entre le substrat et une première structure de colonne connectée à la deuxième surface principale et disposer un deuxième élément de ressort entre le substrat et une deuxième structure de colonne connectée à la deuxième surface principale; **caractérisé par le fait que** le premier élément de ressort ($22_1$) et/ou le deuxième élément de ressort ($22_2$) présentent, le long d'un parcours axial de l'élément de ressort, une articulation (36) qui met à disposition, dans une direction parallèle à une normale à une surface (38b) de la deuxième surface principale (14B), une réduction de rigidité de l'élément de ressort ($22_1$, $22_2$).

**15.** Procédé selon la revendication 14, comportant le fait de générer la première structure de colonne ($24_1$) et/ou la deuxième structure de colonne ($24_2$) par dépôt d'un matériau magnétique pour obtenir une structure de colonne magnétique.

Fig. 1a

Fig. 1b

EP 3 924 295 B1

Fig. 2

EP 3 924 295 B1

Fig. 3a

Fig. 3b

EP 3 924 295 B1

Fig. 4a

EP 3 924 295 B1

Fig. 4b

Fig. 5

EP 3 924 295 B1

Fig. 6

EP 3 924 295 B1

Fig. 7

<u>800</u>

Bereitstellen eines Substrats und einem gegenüber dem
Substrat beweglich aufgehängten Element, das eine erste
Hauptoberfläche und eine gegenüberliegend angeordnete
zweite Hauptoberfläche aufweist

~810

Anordnen eines ersten Federelements zwischen dem
Substrat und einer mit der zweiten Hauptoberfläche
verbundenen ersten Säulenstruktur und ein Anordnen
eines zweiten Federelementes zwischen dem Substrat
und einer mit der zweiten Hauptoberfläche verbundenen
zweiten Säulenstruktur

~820

Fig. 8

äußere
Verbindung

Bewegungstransformator

innere
Verbindung

Mikrospiegelplatte

300

Rotator A

307

302

303

308

Rotator A

304  301  305

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7428353 B1
- US 2014376071 A1

- EP 2670880 B1, V. Milanovic and K. Castelino

**In der Beschreibung aufgeführte Nicht-Patentliteratur**

- **T. REIMER et al.** Temperature-stable NdFeB micromagnets with high-energy density compatible with CMOS back end of line technology. *MRS Advances,* 2016, (1